# EUROPEAN PATENT APPLICATION

(11) **EP 2 426 794 A1**
(43) Date of publication of application: **07.03.2012**
(21) Application number: 10009255.0
(22) Date of filing: 06.09.2010
(51) Int. Cl.: H01R 43/00, G01R 31/28

(54) **Cleaning a contactor in a test-in-strip handler for ICs**

(71) Applicant: Rasco GmbH, 83059 Kolbermoor (DE)
(72) Inventor: Waldauf, Alexander, 6306 Söll (AT); Wammetsberger, Christian, 83059 Kolbermoor (DE)
(74) Representative: Grünecker, Kinkeldey, Stockmair & Schwanhäusser

(57) **Abstract**

The invention provides a method of operating a test-in-strip handler for simultaneously testing a plurality of integrated circuits of an IC-strip, comprising a test cycle and a cleaning cycle; wherein the test cycle comprises the steps of: feeding an IC-strip having a plurality of integrated circuits to a plunger head of the test-in-strip handler (100); contacting the IC-strip on the plunger head with contact pins of the test-in-strip handler (110); performing one or more predetermined tests with the plurality of integrated circuits on the IC-strip (130); removing the IC-strip from the plunger head (140); and feeding a subsequent IC-strip to the plunger head; wherein the method comprises the further steps of: determining whether or not cleaning of one or more contact pins is to be effected (120); if it is determined that cleaning is not to be effected, proceeding with the test cycle; and if it is determined that cleaning is to be effected, starting the cleaning cycle; wherein the cleaning cycle comprises the steps of: moving the plunger head in an x-y-plane to a position in which a cleaning region at the plunger head is opposite to the one or more contact pins (160); and moving the plunger head including the cleaning region in a z-direction perpendicular to the x-y-plane towards and reverse the at least one contact pin (170) for contacting the cleaning region with the at least one contact pin thereby cleaning the one or more contact pins.

## Description

### Field of the Invention

The present invention relates to a method of operating a test-in-strip handler for simultaneously testing a plurality of integrated circuits of an IC-strip, comprising the successive steps of feeding an IC-strip having a plurality of integrated circuits to a plunger head of the test-in-strip handler and contacting the IC-strip on the plunger head with contact pins of the test-in-strip handler.

### Prior Art

For testing the quality of integrated circuits (ICs) so called handlers are operated. The handler places the ICs in contact with an automatic test system to verify their function. Based on the test results, the lCs are sorted by the handler to make them available for packaging or other applications.

A particular type of handler is the so called test-in-strip handler which is configured to simultaneously test a complete strip with a plurality of ICs. A tray of the test-in-strip handler comprises several stacks of IC strips. From these stacks, individual IC strips are fed to a plunger / plunger head that positions the IC strip relative to the contact pins of a contactor. Testing is performed by moving the IC strip in the z-direction towards the contactor, such that the contact pins of the contactor contact corresponding leads of the ICs on the IC strip. Then a test procedure is started in order to test the ICs for correct operation. After testing, the IC strip is unloaded from the plunger and malfunctioning ICs may be marked with an integrated laser marker.

The contact pins in the test-in-strip handler are usually designed as pogo pins arranged in a two dimensional array, wherein each pin is spring loaded. Due to abrasion during many contacts, debris may collect on the contact pins, which deteriorates the contact quality between the pins and the leads of the ICs. In the prior art, the contact pins are cleaned by feeding a cleaning strip (replacement strip) to the plunger that mimics the outlines of the IC strips and cleaning is performed by contacting the cleaning strip instead of an IC strip with the contact pins of the contactor of the test-in-strip device.

However, this method of the prior art has the disadvantage that the cleaning of the contact pins of the conductor is time consuming and difficult to handle. In particular, a complete stack of the tray of the test-in-strip handler has to be reserved for the cleaning strips. Therefore, a smaller total amount of IC strips can be placed in the tray which reduces the efficiency of testing. Moreover, the completion of the steps of loading the cleaning strip in replacement of the IC strip, performing the cleaning and unloading the cleaning strip is time consuming and involves problems relating to the exact feeding and removing of the cleaning strips (loading and unloading) which is related to the design and the material of the cleaning strips.

### Description of the Invention

The problem underlying the present invention in view of the prior art is to provide a method of operating a test-in-strip handler, in particular of cleaning the contact pins of a test-in-strip handler, such that the above-mentioned problems are overcome.

The above-mentioned problem is solved by the method according to claim 1.

The inventive method of operating a test-in-strip handler for simultaneously testing a plurality of integrated circuits of an IC-strip according to claim 1 comprises a test cycle and a cleaning cycle;
wherein the test cycle comprises the steps of:
feeding an IC-strip having a plurality of integrated circuits to a plunger head of the test-in-strip handler;
contacting the IC-strip on the plunger head with contact pins of the test-in-strip handler;
performing one or more predetermined tests with the plurality of integrated circuits on the IC-strip;
removing the IC-strip from the plunger head; and
feeding a subsequent IC-strip to the plunger head;
wherein the method comprises the further steps of:
determining whether or not cleaning of one or more contact pins is to be effected;
if it is determined that cleaning is not to be effected, proceeding with the test cycle; and
if it is determined that cleaning is to be effected, starting the cleaning cycle;
wherein the cleaning cycle comprises the steps of:
moving the plunger head in an x-y-plane to a position in which a cleaning region at the plunger head is opposite to the one or more contact pins; and
moving the plunger head including the cleaning region in a z-direction perpendicular to the x-y-plane towards and reverse the at least one contact pin for contacting the cleaning region with the at least one contact pin thereby cleaning the one or more contact pins.

According to the invention, when it is determined that cleaning is to be effected, for example by detecting that the quality of the electrical contact is insufficient, the cleaning cycle is started in which the plunger head is moved to a position such that a cleaning region that is provided on the plunger head is opposite to at least one contact pin which contact quality has deteriorated, and then the plunger head with the cleaning region is moved in a z-direction perpendicular to the x-y-plane back and forth, towards and reverse the at least one contact pin, such that the cleaning region is contacting the contact pin for cleaning the contact pin. This procedure has the additional advantage that no further material (i.e. cleaning strip for replacing the IC strip) is necessary, which also reduces possible errors to a minimum. This method of operating and cleaning the test-in-strip handler is fast and cheap.

According to a development of the invention, the method may comprise the further step of returning to the determining step after performing the cleaning cycle. Hence, the handler may return to the step of determining whether the quality of the electrical contact between the IC strip and the contact pins is sufficient or insufficient, and if the quality is sufficient, perform the pre-determined test(s), i.e. the handler returns to the test operation mode. On the other hand, if the contact quality is still deteriorated, the cleaning cycle may be performed again.

According to a further development of the invention, the cleaning cycle may further comprise an initial step of removing or unloading the IC strip from the plunger head and a last step of reloading the IC-strip to the plunger head. This has the advantage that the temporarily unloaded IC strip does not interfere with the cleaning process, in particular, a vertical stroke in the z-direction may for example be larger during the cleaning cycle than during the testing cycle which may improve the cleaning quality.

According to another development, the cleaning cycle may comprise the step of moving the plunger head in the z-direction towards and reverse the one or more contact pins several times. This has the advantage that better cleaning results may be achieved.

According to a further development, in the cleaning cycle, a plurality of contact pins may be cleaned simultaneously, in particular, wherein an array of contact pins is cleaned simultaneously. Since the contact pins are arranged in arrays, the cleaning region may be configured such that a simultaneous cleaning of a plurality of contact pins, i.e. one or more arrays of contact pins, is possible, further reducing the cleaning time.

According to another development, the step of determining whether or not cleaning of one or more contact pins is to be effected may be performed by determining whether the quality of electrical contact is sufficient or insufficient, particularly by applying a predetermined voltage to the one or more contact pins and measuring a current through the one or more contact pins or wherein the determining whether or not cleaning of one or more contact pins is to be effected may be performed by counting a number of strips that have been tested since the last cleaning cycle.

By applying a voltage to one or more contact pins, for example as an initial step of the test procedure, it may be determined if a resistance between the contact pin and the corresponding lead of an IC has changed by measuring a current through the contact pin. Alternatively, a number of strips may be counted that has been tested since the last cleaning cycle was performed and if the number exceeds a predetermined threshold, it may be considered that the quality of the electrical contact has deteriorated such that it is insufficient and cleaning is necessary.

According to a further development, the cleaning region may comprise a cleaning material, in particular a cleaning sheet. This has the advantage that available cleaning material can be used.

According to another development, the cleaning element may comprise a block to which the cleaning material is attached and the method may comprise the further step of replacing the block with another block with unused cleaning material after a predetermined number of cleaning cycles. In this way, used up cleaning material may be easily replaced.

According to a further development, different areas or regions of the cleaning material may be used for different cleaning cycles. This has the advantage that one area of the cleaning material after another is used in subsequent cleaning cycles such that an even use of the cleaning material is provided.

According to another development, the cleaning material may be arranged on one or more peripheral portions of the plunger head, in particular wherein the cleaning material may be arranged along a complete perimeter of the plunger head. This has the advantage that the cleaning material is placed at portions of the plunger head that are not occupied by the IC strips and do not interfere with them.

According to a further development, the step of contacting the IC strip on the plunger head of the contact pins may be performed such that each lead of each IC of the IC strip is contacted with a corresponding contact pin.

According to another de velopment, in the cleaning cycle the step of moving the plunger head in the z-direction is performed with a larger stroke than during contacting the IC strip with the contact pins. This has the advantage of achieving a better cleaning result.

According to a further development, in the cleaning cycle the contact pins may at least partially pierce through the cleaning material. This further improves the cleaning results for the contact pins as debris may be wiped off of the contact pins.

According to another development, the plunger head may position the IC strip relative to the contact pins.

The invention also provides a test-in-strip handler according to claim 15.

The test-in-strip handler according to the invention comprises:
a tray for storing a stack of IC-strips;
a feeder for feeding one of the IC-strips;
a plunger head for receiving the IC-strip from the feeder, for positioning the IC-strip;
a contactor having contact pins for contacting leads of ICs on the IC strip;
a cleaning element attached to the plunger head for cleaning the contact pins;
wherein the test-in-strip handler is adapted to perform the method according to the invention or according to a development thereof as described above.

Further features and advantages of the present invention will be described in the following with reference to the figures, which illustrate only examples of embodiments of the present invention. The illustrated and described features may be suitably combined with each other.

### Brief Description of the Drawings

Fig. 1 illustrates a first embodiment of the invention.
Fig. 2 illustrates a second embodiment of the invention.

### Description of the Embodiments

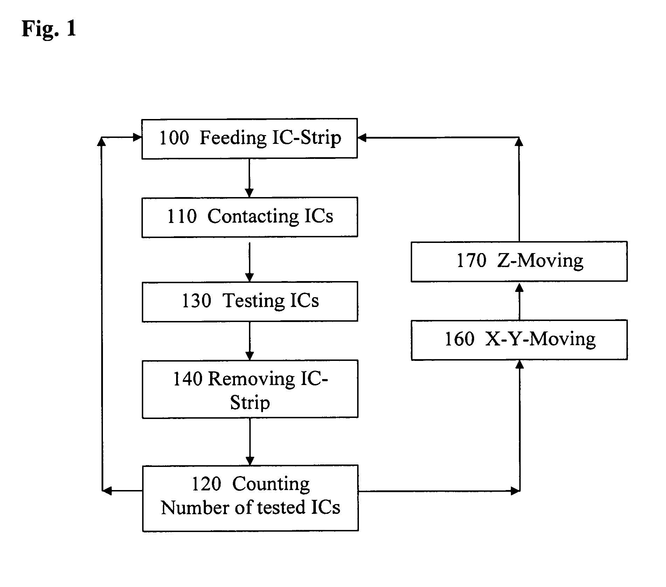

Figure 1 shows a first embodiment of the inventive method.

In this first embodiment of the inventive method, the first step 100 is feeding an IC strip that has a plurality of integrated circuits to the plunger head of the test-in-strip handler. The second step 110 is to contact the IC strip on the plunger head with the contact pins of the contactor of the test-in-strip handler. The next step 130 is to perform one or more predetermined tests with the plurality of integrated circuits on the IC strip. After testing, the next step 140 is to remove the IC strip. At step 120 the number of tested IC strips is increased by on, i.e. the tested IC strips are counted (since the last cleaning cycle). If the number is less than or equal a predetermined number, the method returns to the feeding step 100 for feeding a subsequent IC strip to the plunger head. If, however, the number is larger than the predetermined number, the method proceeds to the cleaning cycle.

The cleaning cycle is started and comprises the step 160 of moving the plunger head in the x-y plane to a position in which a cleaning element at the plunger head is opposite to an array of contact pins and another step 170 of moving the plunger head, including the cleaning region on the plunger head, in the z-direction perpendicular to the x-y plane back and forth relative to the contact pins for contacting the cleaning region of the plunger head with the contact pins thereby cleaning the contact pins. After the cleaning cycle has been completed, the method returns to the feeding step 100.

Suitable cleaning material may for example be obtained from MIPOX, as cleaning sheets (PF-type and SWE-type). Such a sheet may be adhered to the plunger head directly or a replacable cleaning element with a cleaning sheet may be provided at the plunger head.

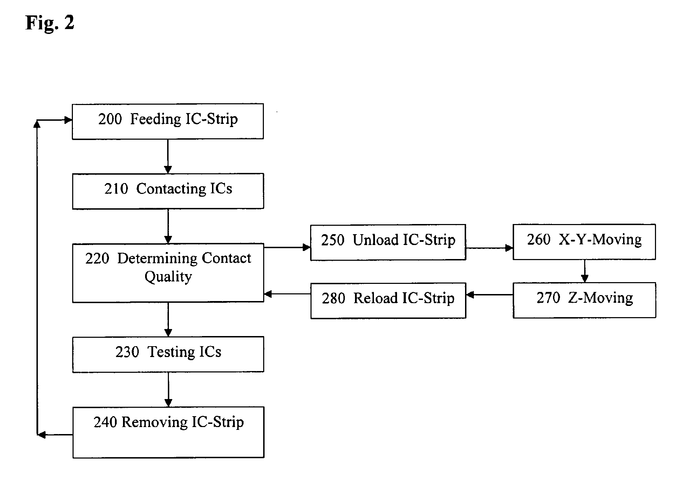

Figure 2 shows a second embodiment of the inventive method, wherein features corresponding to features in the first embodiment have the same reference sign in the last two digits and differ only in the hundreds that is increased from 1 to 2.

In this second embodiment of the inventive method, the first step 200 is feeding an IC strip that has a plurality of integrated circuits to the plunger head of the test-in-strip handler. The second step 210 is to contact the IC strip on the plunger head with the contact pins of the contactor of the test-in-strip handler. The next step 220 is to determine whether a quality of electrical contact between the IC strip and the contact pins is sufficient or insufficient. This is for example done by applying a voltage to the contact pins and measuring a current through the contact pin, in order to determine a resistance.

If it is determined that the quality of the electrical contact is sufficient, the method proceeds to step 230, wherein one or more predetermined tests are performed with the plurality of integrated circuits on the IC strip. After testing, the next step 240 is to remove the IC strip and return to the feeding step 200 for feeding a subsequent IC strip to the plunger head.

If, however, in step 220 it is determined that the quality of the electrical contact is insufficient, the cleaning cycle is started that comprises the step 260 of moving the plunger head in the x-y plane to a position in which a cleaning element at the plunger head is opposite to one or more contact pins with deteriorated contact quality and another step 270 of moving the plunger head, including the cleaning region on the plunger head, in the z-direction perpendicular to the x-y plane back and forth relative to the one or more contact pins for contacting the cleaning region of the plunger head with the at one or more contact pins thereby cleaning the one or more contact pins. After the cleaning cycle has been completed, the method returns to the determining step 220.

In this second embodiment, the cleaning cycle further comprises an initial step of unloading the IC strip from the plunger head before the moving steps 260 and 270 are performed and it comprises a final step 280 of the cleaning cycle of reloading the unloaded IC strip back to the plunger head.

## Claims

1. Method of operating a test-in-strip handler for simultaneously testing a plurality of integrated circuits of an IC-strip, comprising a test cycle and a cleaning cycle;
wherein the test cycle comprises the steps of:
feeding an IC-strip having a plurality of integrated circuits to a plunger head of the test-in-strip handler;
contacting the IC-strip on the plunger head with contact pins of the test-in-strip handler;
performing one or more predetermined tests with the plurality of integrated circuits on the IC-strip;
removing the IC-strip from the plunger head; and
feeding a subsequent IC-strip to the plunger head;
wherein the method comprises the further steps of:
determining whether or not cleaning of one or more contact pins is to be effected;
if it is determined that cleaning is not to be effected, proceeding with the test cycle; and
if it is determined that cleaning is to be effected, starting the cleaning cycle; and
wherein the cleaning cycle comprises the steps of:
moving the plunger head in an x-y-plane to a position in which a cleaning region at the plunger head is opposite to the one or more contact pins; and
moving the plunger head including the cleaning region in a z-direction perpendicular to the x-y-plane towards and reverse the at least one contact pin for contacting the cleaning region with the at least one contact pin thereby cleaning the one or more contact pins.

2. Method according to claim 1, comprising the further step of returning to the determining step after performing the cleaning cycle.

3. Method according to claim 1 or 2, wherein the cleaning cycle further comprises an initial step of unloading the IC-strip from the plunger head and a last step of reloading the IC-strip to the plunger head.

4. Method according to one of claims 1 to 3, wherein in the cleaning cycle the step of moving the plunger head in the z-direction towards and reverse the one or more contact pins is performed several times.

5. Method according to one of claims 1 to 4, wherein in the cleaning cycle a plurality of contact pins is cleaned simultaneously, in particular, wherein an array of contact pins is cleaned simultaneously.

6. Method according to one of claims 1 to 5, wherein the determining whether or not cleaning of one or more contact pins is to be effected is performed by determining whether the quality of electrical contact is sufficient or insufficient, particularly by applying a predetermined voltage to the one or more contact pins and measuring a current through the one or more contact pins or wherein the determining whether or not cleaning of one or more contact pins is to be effected is performed by counting a number of strips that have been tested since the last cleaning cycle.

7. Method according to one of claims 1 to 6, wherein the cleaning region comprises a cleaning material, in particular a cleaning sheet.

8. Method according to claim 7, wherein the cleaning region comprises a block to which the cleaning material is attached and the method comprises replacing the block with another block with unused cleaning material after a predetermined number of cleaning cycles.

9. Method according to claim 7 or 8, wherein different areas of the cleaning material are used for different cleaning cycles.

10. Method according to one of claims 7 to 9, wherein the cleaning material is arranged on one or more peripheral portions of the plunger head, in particular wherein the cleaning material is arranged along a complete perimeter of the plunger head.

11. Method according to one of claims 1 to 10, wherein contacting the IC-strip on the plunger head with the contact pins is performed such that each lead of each IC of the IC-strip is contacted with a corresponding contact pin.

12. Method according to one of claims 1 to 11, wherein in the cleaning cycle the step of moving the plunger head in the z-direction is performed with a larger stroke than during contacting the IC-strip with the contact pins.

13. Method according to one of claims 1 to 12 in combination with claim 7, wherein in the cleaning cycle the contact pins at least partially pierce through the cleaning material or wherein the contact pins are cleaned by the surface of the cleaning material.

14. Method according to one of claims 1 to 13, wherein the plunger head positions the IC-strip relative to the contact pins.

15. Test-in-strip handler comprising:
a tray for storing a stack of IC-strips;
a feeder for feeding one of the IC-strips;
a plunger head for receiving the IC-strip from the feeder, for positioning the IC-strip;
a contactor having contact pins for contacting leads of ICs on the IC strip;
a cleaning element attached to the plunger head for cleaning the contact pins;
wherein the test-in-strip handler is adapted to perform the method according to one of claims 1 to 14.
